(19) Europäisches Patentamt

European Patent Office

Office européen des brevets

(11) EP 1 484 646 A2

(12) EUROPÄISCHE PATENTANMELDUNG

(43) Veröffentlichungstag:
08.12.2004 Patentblatt 2004/50

(51) Int Cl.7: **G03F 7/20**, G02B 26/00

(21) Anmeldenummer: 04013058.5

(22) Anmeldetag: 03.06.2004

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **05.06.2003 DE 10325461**

(71) Anmelder: **Carl Zeiss SMS GmbH**
**07745 Jena (DE)**

(72) Erfinder:
• **Burkhardt, Mathias**
**07768 Eichenberg (DE)**
• **Erdmann, Lars**
**99880 Hörselgau (DE)**
• **Steiner, Reinhardt**
**07646 Stadtroda (DE)**
• **Brunner, Robert**
**07743 Jena (DE)**

(54) **Verfahren und Anordnung zur Realisierung einer schaltbaren optischen Apertur**

(57) Die vorliegende Erfindung betrifft ein optisches System zur Überlagerung mehrerer optischer Wellen. Durch die daraus resultierende Interferenz können verschiedenste Muster für die Photolithografie, die Lasermaterialbearbeitung, eine strukturierte Beleuchtung oder die Messtechnik erzeugt werden.

Bei dem erfindungsgemäßen Verfahren und der Anordnung zur Realisierung einer schaltbaren optischen Apertur, wird ein einfallendes, räumlich kohärentes Lichtbündel (1) in Amplitude und/oder Phase und/oder Polarisation moduliert, durch Linsenarrays (5,6) in Subaperturen aufgeteilt, diese Subaperturen durch Fokussierung in Kugelwellen umgewandelt, von einer Transformationsoptik (8) als ebene Wellen auf die Objektebene (8) kollimiert und dort überlagert werden.

Mit dieser Methode ist die Erzeugung räumlich hochfrequenter Strukturen über große Felder möglich, wie sie beispielsweise in der diffraktiven Optik benötigt werden. Die Zahl der zum Interferenzfeld beitragenden optischen Wellen kann hierbei sehr groß gewählt werden. Bei einer XGA-Auflösung (1024x768 Pixel) würden 786.432 ebene Wellen zum Interferenzfeld beitragen.

Figur 1

**Beschreibung**

Die vorliegende Erfindung betrifft ein optisches System zur Überlagerung mehrerer optischer Wellen. Durch die daraus resultierende Interferenz können verschiedenste Muster für die Photolithografie, die Lasermaterialbearbeitung, eine strukturierte Beleuchtung oder die Messtechnik erzeugt werden. Das Muster belichtet einen speziellen Fotolack und kann in nachfolgenden Prozessen auf den Wafer übertragen werden.

Interferenzfelder, die durch Überlagerung zwei oder mehrerer optischer Wellen entstehen, werden nach dem bekannten Stand der Technik seit längerem bereits zur Erzeugung lithographischer Strukturen bei der Herstellung von Halbleiterbauelementen (integrierte Schaltungen) genutzt. Allerdings ist dieses Verfahren bisher auf die Verwendung zweier oder einiger weniger interferierender Wellen beschränkt. Ein Hauptgrund dafür ist die mit steigender Wellenzahl stark zunehmende Komplexität des Aufbaues sowie der steigende Aufwand bei der Justierung der einzelnen Intensitäten und Phasendifferenzen.

In der Patentschrift US 6,140,660 wird von Mermelstein ein synthetisches optisches Blenden-Array beschrieben. Hierbei wird das Prinzip der Nutzung mehrerer in Amplitude und/oder Phase und/oder Polarisation steuerbarer Wellen zur Erzeugung eines komplizierten Interferenzfeldes beschrieben. Die Phase und/oder die Intensität werden dabei durch akusto-optische Modulatoren, die zwischen Lichtquelle und Objektebene angeordnet und mit einer Steuereinheit verbunden sind, verändert.

Diese Lösung bezieht sich auf eine Methode zum Erzeugen nichtperiodischer Muster durch Interferenz. Die Methode schließt dabei die Schritte des zur Verfügung stellens einer Mehrzahl elektromagnetischer Lichtstrahlen, der gezielten Ausrichtung und des Modulierens deren Phase, Umfanges und/oder Polarisation, um ein vorbestimmtes nichtperiodisches Muster auf der jeweiligen Objektebene zu erzeugen. In Abhängigkeit der zu erzeugenden Interferenzmuster können dabei unterschiedlich viele Lichtquellen verwendet werden. Jede einzelne Lichtquelle wird von einer Steuereinheit so angesteuert, dass sie einen optischen Lichtstrahl vorbestimmter Intensität, Phase und Polarisation aussendet. Die einzelnen Lichtstrahlen werden so ausgerichtet, dass in der Objektebene das gewünschte Interferenzmuster entsteht.

Allerdings wird von Mermelstein zwar das Prinzip, jedoch kein praktikables System beschrieben, mit welchem das synthetische optische Blenden-Array realisiert werden kann.

Der vorliegenden Erfindung liegt die Aufgabe zugrunde eine Lösung zu entwickeln mit der räumlich hochfrequente optische Intensitätsverteilungen bei möglichst geringem Aufwand für Gerätetechnik und Justierung erzeugt werden können. Dabei sollen beliebige Strukturverteilungen über große Felder erzeugt werden können.

Erfindungsgemäß wird die Aufgabe durch die Merkmale der unabhängigen Ansprüche gelöst. Bevorzugte Weiterbildungen und Ausgestaltungen sind Gegenstand der abhängigen Ansprüche.

Typische Anwendungen für derartige Systeme mit großen Interferenzfeldern sind neben der maskenlosen Photolithographie, der Lasermaterialbearbeitung, der strukturierte Beleuchtung auch die Messtechnik.

Die Erfindung wird nachfolgend anhand eines Ausführungsbeispieles beschrieben. Dazu zeigen:

Figur 1:    ein optisches System zur Erzeugung schaltbaren optischen Apetur und

Figur 2:    Schema zur Berechnung der Richtungscosinusse.

Die Erfindung betrifft ein Verfahren zur Realisierung einer schaltbaren optischen Apertur, bei dem ein einfallendes, räumlich kohärentes Lichtbündel **1** in Amplitude und/oder Phase und/oder Polarisation moduliert, durch Linsenarrays **5** und **6** in Subaperturen aufgeteilt, diese Subaperturen durch Fokussierung in Kugelwellen umgewandelt und von einer Transformationsoptik **7** als ebene Wellen in die Objektebene 8 kollimiert und dort überlagert werden. Dabei kann jede Subapertur getrennt in Amplitude und/oder Phase und/oder Polarisation moduliert werden.

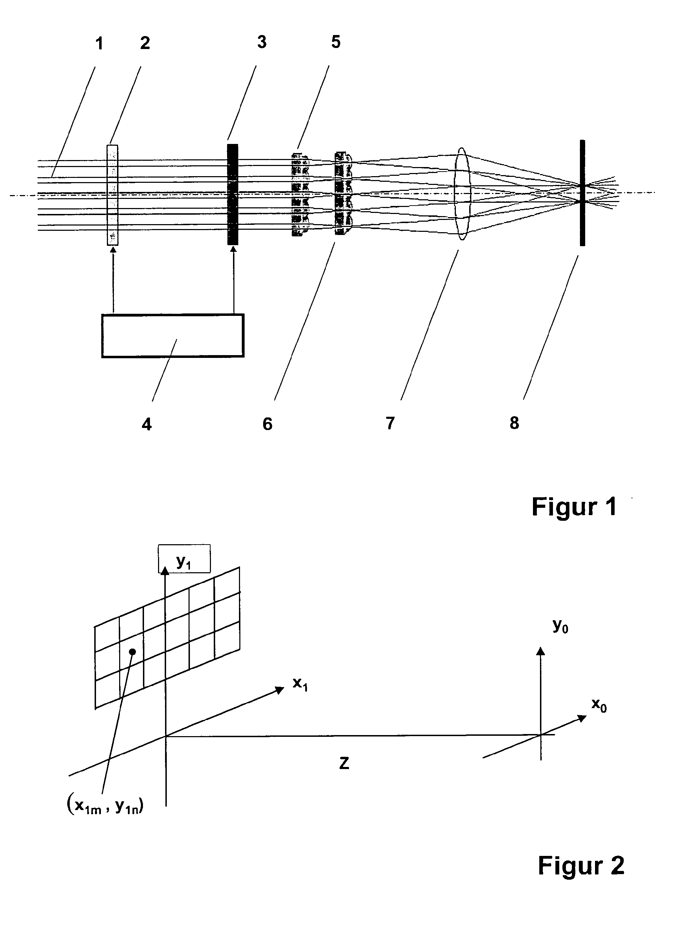

**Figur 1** zeigt eine Anordnung zur Durchführung des erfindungsgemäßen Verfahrens. Dabei besteht die Anordnung aus ein oder mehreren Lichtmodulatoren **2** und **3** zur Modulation eines einfallenden, räumlich kohärenten Lichtbündels in Amplitude und/oder Phase und/oder Polarisation, einer mit dem/den Lichtmodulatoren **2** und **3** verbundenen Steuereinheit **4**, ein oder mehreren Linsenarrays **5** und **6** zur Aufteilung des Lichtbündels **1** in Subaperturen und zur Fokussierung in Kugelwellen sowie einer Transformationsoptik **7** zum Kollimieren und Überlagern der Kugelwellen als ebene Wellen auf die Objektebene **8**. Durch Verwendung eines zweiten Linsenarrays können die bei Verwendung nur eines Linsenarrays auftretende Beugungseffekte (Fresnel-Ringe) in der Objektebene **8** vermieden werden.

Die sowohl in Transmission als auch in Reflexion einsetzbaren Lichtmodulatoren **2** und **3** sind räumlich arbeitende Lichtmodulatoren, die auch als SLM (Spatial Light Modulator) bezeichnet werden.

Die verwendeten Lichtmodulatoren **2** und **3** können dabei auf unterschiedlichen optischen Systemen basieren. Es sind beispielsweise LCOS (Liquid Crystal On Silicon), LCD (Liquid Crystal Displays), DMD (Digital Multimirror Device) aber auch GLV (Grating Light Valves) einsetzbar. LC-Systeme bieten dabei auch die Möglichkeit zur räumlich aufgelösten Phasenmodulation.

Nach der Modulation des räumlich kohärenten Lichtbündels 1 durch die beiden Lichtmodulatoren 2 und 3 erfolgt durch ein erstes Linsenarray 5 eine Aufteilung in Subaperturen. Dabei sollte die Modulation vor dem ersten Linsenarray 5 so erfolgen, dass jede Subapertur getrennt in Amplitude und/oder Phase und/oder Polarisation moduliert werden kann. Das Licht aus den einzelnen Subaperturen wird von einem zweiten Linsenarray 6 durch Fokussierung in Kugelwellen umgewandelt. Diese Kugelwellen werden von einer Transformationsoptik 7 kollimiert und in der Objektebene 8 als ebene Welle überlagert. Dieses zweite Linsenarray 6 besteht aus Feldlinsen und dient der Vermeidung von Beugungseffekten. Die Berandung der Intensitätsverteilung in der Objektebene 8 ist durch die Form des ersten Linsenarrays 5 vorgegeben. Die Linsenarrays 5 und 6 können refraktiv oder diffraktiv sein. Die zeitliche Kohärenz des einfallenden Lichtbündels 1 muss ausreichend sein um auch bei großen Kippwinkeln der generierten ebenen Wellen vollständige Interferenz in der gesamten Objektebene 8 zu gewährleisten. In der Objektebene 8 können dann sehr komplexe, nichtperiodische Amplitudenverteilungen generiert werden:

$$\overline{A}(x, y) = \sum_{m,n} \left[ A_{mn} e^{i\theta_{mn}} \right] e^{i\left[ \frac{2\pi}{\lambda} [\alpha_{mn} x + \beta_{mn} y] \right]}. \qquad (1)$$

In Gleichung (1) bedeuten $A_{mn}$ die Amplituden und $\theta_{mn}$ die Phasen in den Subaperturen. Diese beiden Parameter können über die räumlichen Lichtmodulatoren **2** und **3** gesteuert werden. Dabei bezeichnen m und n die entsprechende Subapertur. Die Richtungscosinusse $\alpha_{mn}$ und $\beta_{mn}$ ergeben sich, gemäß **Figur 2**, aus der Geometrie der Anordnung (Periode des Linsenarrays und Brennweite der Transformationsoptik). Die Ebene $(x_1, y_1)$ entspricht dabei der Hauptebene der Transformationsoptik **7**. Die Richtungscosinusse $\alpha_{mn}$ und $\beta_{mn}$ werden wie folgt berechnet:

$$\alpha_{mn} = \frac{x_{1m}}{\sqrt{x_{1m}^2 + y_{1n}^2 + z^2}}. \qquad (2)$$

$$\beta_{mn} = \frac{y_{1n}}{\sqrt{x_{1m}^2 + y_{1n}^2 + z^2}}. \qquad (3)$$

Da die Gleichung (1) eine Fourier-Summe darstellt, können über die Steuerung von Amplitude und Phase der einzelnen Wellenkomponenten beliebige Amplitudenverteilungen erzeugt werden. Begrenzend sind hierbei lediglich das Sampling und die maximal erreichbaren Winkel, die durch die Ausdehnung der beiden Linsenarrays **5** und **6** gegeben sind. Unter Sampling ist hierbei die Anzahl der Stützstellen bzw. der Pixel, für die digitale Abtastung der eigentlich analogen Funktion zu verstehen (Sampling- oder auch Abtast-Theorem). Durch Quadrierung der Gleichung (1) ergibt sich, dass somit beliebige Intensitätsverteilungen erzeugt werden können.

Die Anforderungen an die Transformationsoptik 7 nehmen im Fall großer Richtungscosinusse $\alpha_{mn}$ und $\beta_{mn}$ zu, weil das zu übertragende Feld größer wird. Nur so können aber große Ortsfrequenzen realisiert werden.

In einer besonderen Ausführungsform werden die beiden Linsenarrays 5 und 6 als Zylinderlinsenarray ausgeführt. Dazu ist es erforderlich, dass auch eine Zylinder-Transformationsoptik **7** zum Einsatz kommt. Dies hat den Vorteil, dass sich eindimensionale Strukturen, wie beispielsweise Beugungsgitter somit viel einfacher herstellen lassen, weil so eine Richtung unendlich dicht gesampelt ist.

Mit dieser Methode ist die Erzeugung räumlich hochfrequenter Strukturen über große Felder möglich, wie sie beispielsweise in der diffraktiven Optik benötigt werden. Die Zahl der zum Interferenzfeld beitragenden optischen Wellen kann hierbei sehr groß gewählt werden. Bei einer XGA-Auflösung (1024x768 Pixel) würden 786.432 ebene Wellen zum Interferenzfeld beitragen.

**Patentansprüche**

1. Verfahren zur Realisierung einer schaltbaren optischen Apertur, bei dem ein einfallendes, räumlich kohärentes Lichtbündel (1) in Amplitude und/oder Phase und/oder Polarisation moduliert, durch Linsenarrays (5, 6) in Subaperturen aufgeteilt, diese Subaperturen durch Fokussierung in Kugelwellen umgewandelt und von einer Transformationsoptik (7) als ebene Wellen auf die Objektebene (8) kollimiert und dort überlagert werden.

2. Verfahren nach Anspruch 1, bei dem jede Subapertur getrennt in Amplitude und/oder Phase und/oder Polarisation moduliert werden kann.

3. Anordnung zur Realisierung einer schaltbaren optischen Apertur, bestehend aus ein oder mehreren Lichtmodulatoren (2, 3) zur Modulation eines einfallenden, räumlich kohärenten Lichtbündels (1) in Amplitude und/oder Phase und/oder Polarisation, einer mit dem/den Lichtmodulatoren (2, 3) verbundenen Steuereinheit (4), ein oder mehreren Linsenarrays (5, 6) zur Aufteilung des Lichtbündels (1) in Subaperturen und zur Fokussierung in Kugelwellen sowie einer Transformationsoptik (7) zum Kollimieren und Überlagern der Kugelwellen als ebene Wellen auf die Objektebene (8).

4. Anordnung nach Anspruch 3, bei der die Lichtmodulatoren (2, 3) sowohl in Transmission als auch in Reflexion einsetzbar sind.

**Figur 1**

**Figur 2**